# EUROPÄISCHE PATENTSCHRIFT

(11) **EP 0 502 231 B1**
(45) Veröffentlichungstag und Bekanntmachung des Hinweises auf die Patenterteilung: **01.05.1996**
(21) Anmeldenummer: 91103450.2
(22) Anmeldetag: 07.03.1991
(51) Int. Cl.: G08C 25/00, H03K 5/01

(54) **Verfahren und Schaltungsanordnung zur Unterdrückung eines Störimpulses in digitalen Interpolationswerten einer Positionsmesseinrichtung**
Method and arrangement for suppressing an interfering impulse in digital interpolation values in a position measuring device
Méthode et dispositif pour éliminer une impulsion de perturbation des valeurs numériques d'interpolation dans un appareil de mesure de position

(43) Veröffentlichungstag der Anmeldung: 09.09.1992
(73) Patentinhaber: Dr. Johannes Heidenhain GmbH, D-83292 Traunreut (DE)
(72) Erfinder: Lengenfelder, Hans, Dipl.-Ing., W-8260 Mühldorf (DE)

(56) Entgegenhaltungen:
- EP-A- 0 309 849
- DE-C- 3 528 796
- PATENT ABSTRACTS OF JAPAN vol. 14, no. 51 (E-881)(3994) 30. Januar 1990 & JP-A-1 277 020
- PATENT ABSTRACTS OF JAPAN vol. 8, no. 194 (E-264)(1631) & JP-A-59 081 953

## Beschreibung

Die Erfindung betrifft ein Verfahren und eine Schaltungsanordnung zur Unterdrückung eines Störimpulses in digitalen Interpolationswerten einer Positionsmeßeinrichtung.

Aus der DE-B-12 21 668 ist ein Verfahren und eine Schaltungsanordnung zur Fehlervermeidung bei einer Informationsübertragung bekannt, bei dem in einen Übertragungsweg eingekoppelte Störimpulse unterdrückt werden, indem die zu übertragenden binären Signale als komplementäre Signale gleicher Phasenlage auf verschiedenen Kanälen einem logischen Netzwerk auf der Empfängerseite zugeführt werden. Am Ausgang des logischen Netzwerks wird nur dann ein Ausgangssignal abgegeben, wenn auf beiden Übertragungskanälen gleichzeitig zwei komplementäre Signale eintreffen.

Der DE-C2-35 28 796 entnimmt man eine Positionsmeßeinrichtung zum Messen der Relativlage zweier Objekte, bei der eine inkrementale Meßteilung von einer Abtasteinheit zur Erzeugung von periodischen Abtastsignalen abgetastet wird, die nach einer Umwandlung in periodische Rechtecksignale von der Abtasteinheit über eine Übertragungsstrecke an eine Auswerteeinrichtung zur Gewinnung von Meßwerten für die Relativlage der beiden Objekte übertragen werden. Zur Erkennung eingekoppelter Störimpulse, insbesondere in die Übertragungsleitungen zwischen der Abtasteinheit und der Auswerteeinrichtung, wird aus zwei periodischen Rechtecksignalen vor ihrer Übertragung in der Abtasteinheit durch eine logische Verknüpfung ein erstes binäres Prüfsignal erzeugt, das an die Auswerteeinrichtung übertragen wird. Gleichfalls wird aus den beiden übertragenen periodischen Rechtecksignalen in der Auswerteeinrichtung ein zweites binäres Prüfsignal durch eine logische Verknüpfung gewonnen, das mit dem übertragenen ersten binären Prüfsignal einem Vergleicher zugeführt wird, der bei einer Ungleichheit der beiden binären Prüfsignale ein Fehlersignal erzeugt. Diese relativ aufwendige Einrichtung vermag zwar eingekoppelte Störimpulse zu erkennen, aber nicht zu unterdrükken.

In der EP-A-0 309 849 ist eine Anordnung zur Unterdrückung von Störimpulsen eines Digitalsignales beschrieben, die eine Verzögerungseinheit sowie ein UND-Gatter als Logikeinheit enthält. Das Digitalsignal und das verzögerte Digitalsignal werden UND-verknüpft, wodurch Impulse ausgeblendet werden, welche sich mit dem verzögerten Impuls nicht überlappen.

In der JP-A-59-81953 sowie der JP-A-1-277020 sind weitere Anordnungen zur Unterdrückung von kurzen Störimpulsen eines Digitalsignales mittels einer Verzögerungseinheit bekannt.

Der Erfindung liegt die Aufgabe zugrunde, ein Verfahren und eine Schaltungsanordnung zur Unterdrükkung wenigstens einer elektrischen Störgröße bei wenigstens einer elektrischen Nutzgröße anzugeben, das die mit einfachen Mitteln eine hohe Zuverlässigkeit aufweist.

Diese Aufgabe wird erfindungsgemäß durch die kennzeichnenden Merkmale des Anspruches 1 und des Anspruches 2 gelöst.

Die mit der Erfindung erzielten Vorteile bestehen insbesondere darin, daß das vorgeschlagene Verfahren eine Gewinnung und Auswertung einwandfreier elektrischer Nutzgrößen ermöglicht, da unvermeidbar eingekoppelte elektrische Störgrößen durch ihre sofortige Unterdrückung keinen negativen Einfluß ausüben können. Dieses Verfahren ist bei Positionsmeßeinrichtungen mit besonderem Erfolg anwendbar, deren periodische Abtastsignale mit einem hohen Unterteilungsgrad interpoliert werden sollen.

Eine vorteilhafte Ausbildung der Erfindung entnimmt man dem abhängigen Anspruch.

Ein Ausführungsbeispiel der Erfindung wird anhand der Zeichnung näher erläutert.

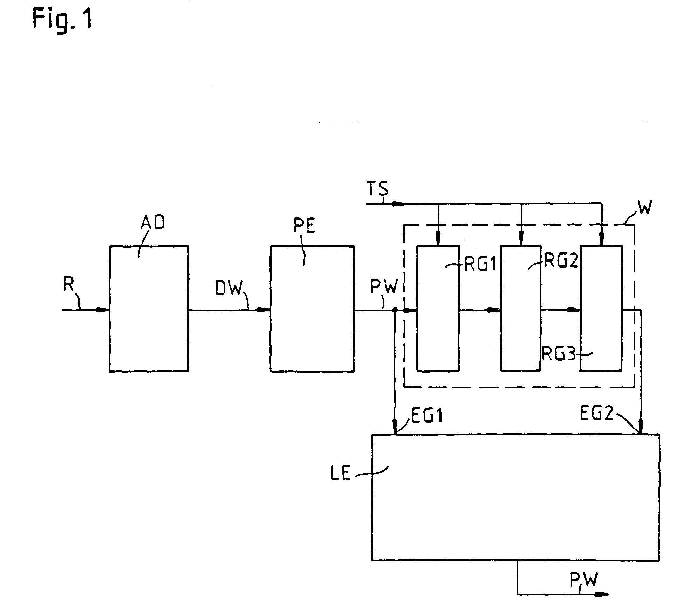

Es zeigt
- Figur 1: eine Schaltungsanordnung zur Unterdrückung von Störimpulsen bei Interpolationswerten einer Positionsmeßeinrichtung.

Figur 1 zeigt eine Schaltungsanordnung zur Unterdrückung von elektrischen Störgrößen in Form von Störimpulsen bei elektrischen Nutzgrößen in Form von digitalen Werten, insbesondere von Interpolationswerten einer nicht dargestellten Positionsmeßeinrichtung. Ein von dieser Positionsmeßeinrichtung geliefertes periodisches Rechtecksignal R wird von einem Analog-Digital-Wandlers AD in Digitalwerte DW umgewandelt, aus denen in einer Interpolationseinheit PE mit einer Interpolationstabelle digitale Interpolationswerte PW gewonnen werden, die einmal einem ersten Eingang EG1 einer Logikeinheit LE und nach Durchlaufen einer Verzögerungseinheit W einem zweiten Eingang EG2 dieser Logikeinheit LE zugeführt werden. die Logikeinheit LE besteht aus drei hintereinandergeschalteten Registern RG1, RG2, RG3, die jeweils von einem gemeinsamen Taktsignal TS einer nicht gezeigten Takteinheit beaufschlagt werden.

Jeder am ersten Eingang EG1 der Logikeinheit LE anstehende neue Interpolationswert PW wird erst dann als korrekter Interpolationswert PW am Ausgang der Logikeinheit LE weitergegeben, wenn er sich selbst durch sein Erscheinen am zweiten Eingang EG2 der Logikeinheit LE nach der Verzögerungszeit durch die Verzögerungseinheit W bestätigt hat.

In nicht dargestellter Weise kann die Verzögerungseinheit W auch nur ein Register aufweisen, das von einem Taktsignal mit der dreifachen Taktzeit beaufschlagt ist.

Zur Erhöhung der Sicherheit können noch weitere Verzögerungseinheiten für eine mehrfache Bestätigung nachgeschaltet werden.

## Patentansprüche

1. Verfahren zur Unterdrückung eines Störimpulses in digitalen Interpolationswerten einer Positionsmeßeinrichtung mit folgenden Merkmalen:
a) ein von der Positionsmeßeinrichtung geliefertes periodisches Rechtecksignal (R) wird von einem Analog-Digital-Wandler (AD) in Digitalwerte (DW) umgewandelt,
b) aus den Digitalwerten (DW) werden in einer Interpolationseinheit (PE) mit einer Interpolationstabelle digitale Interpolationswerte (PW) gewonnen,
c) die digitalen Interpolationswerte (PW) werden einmal einem ersten Eingang (EG1) einer Logikeinheit (LE) und zum anderen einem Eingang einer Verzögerungseinheit (W) zugeführt,
d) der am Ausgang der Verzögerungseinheit (W) nach einer bestimmten Verzögerungszeit erscheinende digitale Interpolationswert (PW) wird einem zweiten Eingang (EG2) dieser Logikeinheit (LE) zugeleitet,
e) jeder am ersten Eingang (EG1) der Logikeinheit (LE) anstehende neue Interpolationswert (PW) wird erst dann als korrekter Interpolationswerte (PW) an den Ausgang der Logikeinheit (LE) weitergegeben, wenn er sich selbst durch sein Erscheinen am zweiten Eingang (EG2) der Logikeinheit (LE) nach der Verzögerungszeit durch die Verzögerungseinheit (W) bestätigt hat.

2. Schaltungsanordung zur Unterdrückung eines Störimpulses in digitalen Interpolationswerten einer Positionsmeßeinrichtung mit folgenden Merkmalen:
a) der Positionsmeßeinrichtung ist ein Analog-Digital-Wandler (AD) nachgeschaltet, dem ein periodisches Rechtecksignal der Positionsmeßeinrichtung zugeführt wird,
b) dem Analog-Digital-Wandler (AD) ist eine Interpolationseinheit (PE) nachgeschaltet, welche die Digitalwerte (DW) des Analog-Digital-Wandlers (AD) interpoliert und digitale Interpolationswerte (PW) bildet,
c) der Interpolationseinheit (PE) ist eine Verzögerungseinheit (W) sowie eine Logikeinheit (LE) nachgeschaltet, wobei der Ausgang der Interpolationseinheit (PE) an einem Eingang (EG1) der Verzögerungseinheit (W) sowie an die Logikeinheit (LE) angeschlossen ist und der Ausgang der Verzögerungseinheit (W) an einem weiteren Eingang (EG2) der Logikeinheit (LE) angeschlossen ist, und
d) am Ausgang der Logikeinheit (LE) ein korrekter Interpolationswert (PW) ansteht, wenn er sich selbst durch sein Erscheinen am zweiten Eingang (EG2) der Logikeinheit (LE) nach einer Verzögerungszeit durch die Verzögerungseinheit (W) bestätigt hat.

3. Schaltungsanordnung nach Anspruch 2, dadurch gekennzeichnet, daß die Verzögerungseinheit (W) entsprechend einer bestimmten Verzögerungszeit mehrere hintereinandergeschaltete Register (RG1, RG2, RG3) aufweist, die jeweils von einem gemeinsamen Taktsignal (TS) einer Takteinheit beaufschlagt sind.

## Claims

1. Method for suppressing an interference pulse in interpolation values of a position-measuring device with the following features:
a) a periodic square wave signal (R) delivered by the position-measuring device is converted by an analog-digital converter (AD) into digital values (DW),
b) in an interpolation unit (PE) with an interpolation table, digital interpolation values (PW) are obtained from the digital values (DW),
c) the digital interpolation values (PW) are passed on the one hand to a first input (EG1) of a logical unit (LE), and on the other hand to one input of a retardation unit (W),
d) the digital interpolation value (PW) appearing after a specific delay time at the output of the retardation unit (W), is passed to a second input (EG2) of this logical unit (LE),
e) each new interpolation value (PW) present at the first input (EG1) of the logical unit (LE) is only passed on as a correct interpolation value (PW) to the output of the logical unit (LE) when it has confirmed itself by its appearance at the second input (EG2) of the logical unit (LE) after the delay time by the retardation unit (W).

2. Circuit arrangement for suppressing an interference pulse in digital interpolation values of a position-measuring device with the following features:
a) incorporated after the position-measuring device is an analog-digital converter (AD), to which there is passed a periodic square wave signal of the position-measuring device,
b) incorporated after the analog-digital converter (AD) is an interpolation unit (PE), which interpolates the digital values (DW) of the analog-digital converter (AD) and forms digital interpolation values (PW),
c) incorporated after the interpolation units (PE) are a retardation unit (W) and a logical unit (LE), the output of the interpolation unit (PE) being connected to one input (EG1) of the retardation unit (W) and to the logical unit (LE), and the output of the retardation unit (W) being connected to a further input (EG2) of the logical unit (LE), and
d) there is present at the output of the logical unit (LE) a correct interpolation value (PW) when it has confirmed itself by its appearance at the second input (EG2) of the logical unit (LE) after a delay period by the retardation unit (W).

3. Circuit arrangement according to Claim 2, characterised in that the retardation unit (W) has a plurality of registers (RG1, RG2, RG3) incorporated in series and corresponding to a specific delay time, said registers being respectively charged with a common timing signal (TS) from a timing unit.

## Revendications

1. Procédé pour éliminer une impulsion perturbatrice dans des valeurs numériques d'interpolation d'un dispositif de mesure de position, présentant les caractéristiques suivantes:
a) un signal carré (R) périodique délivré par le dispositif de mesure de position est converti en valeurs numériques par un convertisseur analogique-numérique (AD),
b) des valeurs numériques d'interpolation (PW) sont formées à partir des valeurs numériques (DW) dans une unité d'interpolation (PE) avec une table d'interpolation,
c) les valeurs numériques d'interpolation (PW) sont appliquées d'une part à une première entrée (EG1) d'un circuit logique (LE) et d'autre part à une entrée d'une unité de temporisation (W),
d) la valeur numérique d'interpolation (PW) qui apparaît à la sortie de l'unité de temporisation (W) après une durée de temporisation est transmise à une deuxième entrée (EG2) de l'unité logique (LE),
e) chaque nouvelle valeur d'interpolation (PW) appliquée à la première entrée (EG1) de l'unité logique n'est transmise à la sortie de l'unité logique (LE) en tant que valeur d'interpolation (PW) correcte que lorsque celle-ci s'est auto confirmée par son apparition à la deuxième entrée (EG2) de l'unité logique (LE) après la durée de temporisation imposée par l'unité de temporisation.

2. Agencement de circuit pour éliminer une impulsion perturbatrice dans des valeurs numériques d'interpolation d'un dispositif de mesure de position, présentant les caractéristiques suivantes:
a) un convertisseur analogique-numérique (AD) auquel est envoyé un signal carré périodique produit par le dispositif de mesure de position est placé à la suite du dispositif de mesure de position,
b)une unité d'interpolation (PE) qui interpole les valeurs numériques (DW) du convertisseur analogique-numérique (AD) et forme des valeurs d'interpolation (PW) est placée à la suite du convertisseur analogique-numérique (AD),
c) une unité de temporisation (W) ainsi qu'une unité logique (LE) sont placées à la suite de l'unité d'interpolation (PE), la sortie de l'unité d'interpolation (PE) étant connectée à une entrée (EG1) de l'unité de temporisation (W) et à l'unité logique (LE) et la sortie de l'unité de temporisation (W) étant connectée à une entrée (EG2) supplémentaire de l'unité logique (LE) et,
d) une valeur d'interpolation (PW) correcte étant disponible à la sortie de l'unité logique (LE) lorsque celle-ci s'est autoconfirmée par son apparition à la deuxième entrée (EG2) de l'unité logique (LE) après un temps de temporisation imposé par l'unité de temporisation (W).

3. Agencement de circuit selon la revendication 2, caractérisé par le fait que l'unité de temporisation (W), conformément à un temps de temporisation défini, présente plusieurs registres (RG1, RG2, RG3) connectés l'un à la suite de l'autre qui reçoivent un signal d'horloge (TS) commun provenant d'une horloge.
